# EUROPEAN PATENT SPECIFICATION

(11) **EP 2 162 983 B1**
(45) Date of publication and mention of the grant of the patent: **06.10.2010**
(21) Application number: 08766845.5
(22) Date of filing: 26.06.2008
(51) Int. Cl.: H03F 3/217

(54) **PWM AMPLIFIER**
PWM-VERSTÄRKER
AMPLIFICATEUR À MODULATION D'IMPULSIONS EN DURÉE (PWM)

(30) Priority: 03.07.2007 NL 1034082
(43) Date of publication of application: 17.03.2010
(73) Proprietor: Universiteit Leiden, 2300 RA Leiden (NL)
(72) Inventor: VAN SPENGEN, Willem Merlijn, NL-1058 BN Amsterdam (NL)
(74) Representative: Dokter, Hendrik Daniel
(86) International application number: PCT/NL2008/050422
(87) International publication number: WO 2009/005345

(56) References cited:
- US-A1- 2006 280 314
- KIM M ET AL: "A Monolithic MEMS Switched Dual-PathPower Amplifier" IEEE MICROWAVE AND WIRELESS COMPONENTS LETTERS, IEEE SERVICE CENTER, NEW YORK, NY, US, vol. 11, no. 7, July 2001 (2001-07), XP011038748 ISSN: 1531-1309

## Description

The invention relates to an amplifier device of the pulse width modulation amplifier type (PWM amplifier).

A PWM amplifier is a power amplifier which is for instance applied to control an electric motor or as audio amplifier. The operation thereof is based on the principle of pulse width modulation, in which a signal to be amplified and a periodic signal, for instance a triangular wave, are fed to a comparator. The frequency of the triangular wave is chosen such that it is much higher than the frequency of the signal to be amplified. If the signal to be amplified has a higher amplitude than the current amplitude of the triangular wave, the output voltage of the comparator is high, otherwise it is low. The signal to be amplified is thus represented by the width of the pulses in a block signal at the output of the comparator. This block signal is fed to one or more power switches, which can operate at tens to hundreds of volts and many amperes. The thus amplified block signal is then fed to a low-pass filter where the original signal, now with high power, is recovered.

In the known PWM amplifier use is made, for the purpose of performing the switching functions therein, of one or more transistors, which generate an amount of noise.

Partly due to the application of MOS and/or bipolar technology therein, the known PWM amplifier is sensitive to very high and low temperatures and to radioactive radiation, and is therefore less suitable for use in an environment where such radiation occurs, for instance in measuring equipment used in scientific research.

The publication Kim M ET AL: "A Monolithic MEMS Switched Dual-PathPower Amplifier" IEEE MICROWAVE AND WIRELESS COMPONENTS LETTERS, IEEE SERVICE CENTER, NEW YORK, NY, US, vol. 11, no. 7, July 2001 (2001-07) , pages 285-286, discloses an amplifier using monolitic MEMS switches to switch the input signal between two input paths.

It is an object of the invention to provide a PWM amplifier which generates no or at least minimal noise and is thus particularly suitable for use as preamplifier.

It is also an object to propose such an amplifier which can be produced as an integrated circuit, which does not necessarily have to be compatible with CMOS and bipolar technology.

It is a further object to provide a PWM amplifier which is suitable for exposure to very high or low temperatures or to radioactive radiation.

These objects are achieved, and other advantages gained, with an amplifier device of the type stated in the preamble, which according to the invention comprises a switch according to a micro-electromechanical system (MEMS-switch) for a signal to be amplified (Vᵢ), which MEMS switch comprises at least one substrate on which are arranged a movable thin film of an electrically conductive material, a first electrode forming the input for the signal to be amplified (Vᵢ), a second electrode forming the output for a pulse width-modulated signal (V_{PWM}), and actuator means for moving the thin film subject to the signal to be amplified (Vᵢ), wherein the amplifier device is adapted to generate the pulse width-modulated signal (V_{PWM}) subject to the movement of the thin film.

A MEMS switch is available as a microelectronic circuit, in which a variable capacitor can be switched between a high and a low capacity using a control voltage. A MEMS switch is applied particularly as switch for radio-frequency (RF) waves with a frequency in the gigahertz (GHz) range.

Because a MEMS switch consists essentially of only a capacitor, it does not cause any noise (apart from the thermal movement of the mechanical parts), and exceptionally little noise is generated in a PWM amplifier which according to the invention comprises a MEMS switch.

The actuator means in such a device are for instance formed by a third electrode which is adapted as actuator electrode for supplying a modulator signal (Vm) thereon for the purpose of moving the thin film, wherein the first and the third electrode form the inputs of a comparator circuit.

In an embodiment of an amplifier device according to the invention the MEMS switch comprises a conductor-conductor contact of the thin film and the second electrode.

In a subsequent embodiment the MEMS switch comprises a capacitive contact of the thin film and the second electrode.

A capacitive contact provides the advantage that no direct contact is required between the thin film and the second electrode for the proper functioning of the MEMS switch, as a result of which the reliability of a MEMS switch with a capacitive contact is greater than that of a MEMS switch with a conductor-conductor contact.

In an embodiment of an amplifier device with a MEMS switch with a capacitive contact, this contact is provided by an air gap between the thin film and the second electrode, and the thin film is provided on its side directed toward the substrate and/or the substrate is provided on its side directed toward the thin film with at least one spacer.

The electrically conductive material of the thin film in an amplifier device according to the invention is for instance selected from the group of materials aluminium (Al), polycrystalline silicon (Si), doped polycrystalline silicon, carbon (C), SiC, germanium (Ge), germanium-silicon alloys, titanium (Ti), titanium nitrides, nickel (Ni), copper (Cu), tantalum (Ta), tungsten (W), gold (Au) and stacks of at least two of these materials.

The invention will be elucidated hereinbelow on the basis of exemplary embodiments and with reference to the drawings.

In the drawings
Fig. 1 shows a schematic view of a first embodiment of a PWM amplifier according to the invention, with a first MEMS switch in cross-section,
Fig. 2 is a schematic top view of the MEMS switch shown in fig. 1,
Fig. 3 shows a schematic view of a second embodiment of a PWM amplifier according to the invention, with a second MEMS switch in cross-section,
Fig. 4 is a schematic top view of the MEMS switch shown in fig. 3,
Fig. 5 shows a schematic view of a third embodiment of a PWM amplifier according to the invention, with a third MEMS switch in cross-section,
Fig. 6 is a schematic top view of the MEMS switch shown in fig. 5,
Fig. 7 shows a schematic view of a fourth embodiment of a PWM amplifier according to the invention, with a fourth MEMS switch in cross-section, and
Fig. 8 is a graphic representation of the actuator signal for the MEMS switch shown in fig. 7.

Corresponding components are designated in the figures with the same reference numerals.

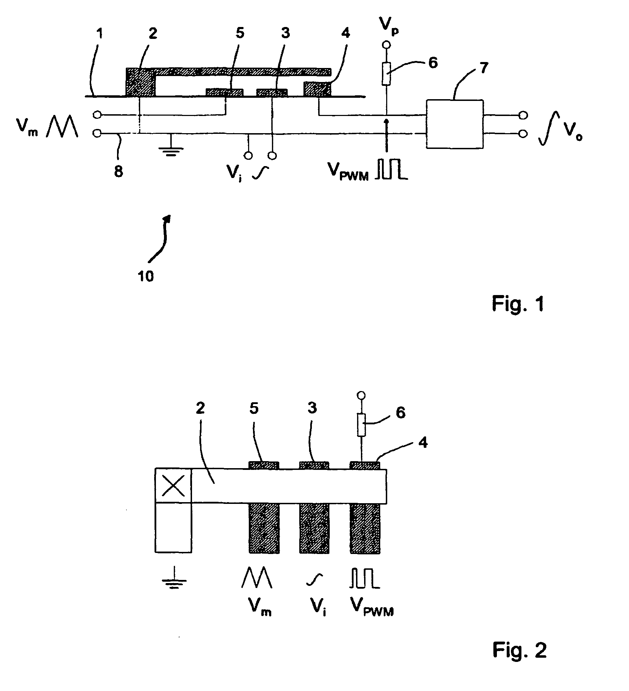

Fig. 1 shows an amplifier 10 with a substrate 1 of for instance a slice of silicon with an insulating nitride layer, on which is arranged a MEMS switch formed by three electrodes 3, 4, 5 and a leaf spring 2 of an electrically conductive, flexible material extending thereover. Leaf spring 2 is connected to earth 8 and can swing down under the influence of a voltage on the left electrode 5 or the middle electrode 3. By applying a triangular voltage Vₘ (the actuator voltage) to left electrode 5 (actuator electrode 5) leaf spring 2 periodically swings downward and leaf spring 5 is short-circuited with right electrode 4 (output electrode 4) when the voltage of triangular wave Vₘ becomes greater than the attraction voltage of the MEMS switch. Leaf spring 2 swings upward again on the downward flank of triangular wave Vₘ. Through the agency of an input signal to be amplified Vᵢ, which is fed to middle electrode 3 (input electrode 3), the moment of downward swing can be moved forward by the extra attraction voltage on input electrode 3. A direct voltage source Vₚ is connected to output electrode 4 via an impedance 6. When leaf spring 2 swings down, the circuit between the direct voltage source Vₚ to earth is short-circuited via impedance 6 and the conductor-conductor contact of leaf spring 2, which results in a PWM square wave V_{PWM} with considerable power which is modulated with the input signal. This PWM signal V_{PWM} is supplied to a low-pass filter 7, the cut-off frequency of which is lower than the frequency of the actuator signal on actuator electrode 5, with the result that the input signal Vᵢ fed to input electrode 3 is recovered in amplified form as output signal Vₒ. Depending on the voltage supplied by direct voltage source Vₚ, the value of impedance 6 and the surface area of the contact between leaf spring 2 and output electrode 4, it is possible to realize a considerable power amplification, voltage amplification and/or current amplification. Input electrode 3 and actuator electrode 5 form the inputs of a comparator circuit in the shown amplifier 10. With respect to noise and for the purpose of an optimal power amplification, it is possible to consider adding a bias voltage to the input signal. It is also possible to replace the triangular voltage with a different periodic voltage in order to optimize the amplification and the noise. For the sake of clarity in the figure the signal forms occurring in amplifier 10 are shown schematically at the respective locations.

Fig. 2 shows a schematic top view of the MEMS switch of amplifier 10 of fig. 1 by way of illustration of the layout of such a switch in an integrated circuit.

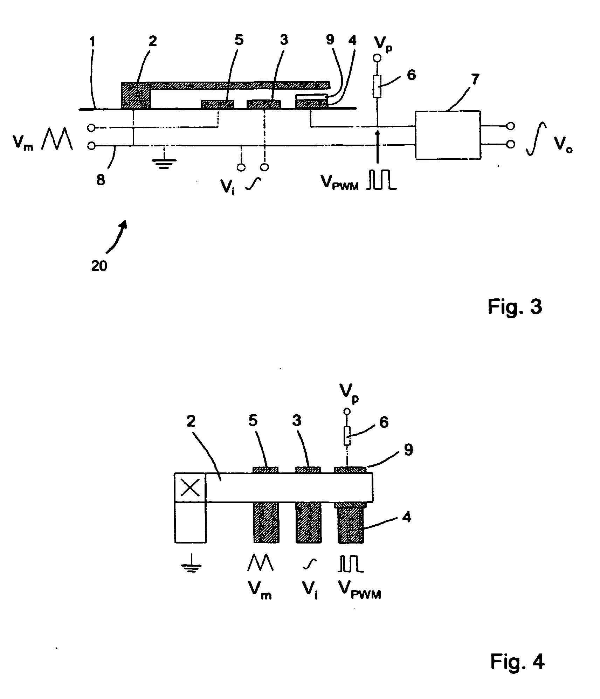

Fig. 3 shows an amplifier 20 which differs from amplifier 10 of fig. 1 in that output electrode 4 is provided on its contact surface with a dielectric 9, for instance of silicon nitride (SiNₓ) or tantalum oxide (Ta₂O₅), as a result of which the contact between leaf spring 2 and output electrode 4 is a capacitive contact. Connected via an impedance 6 to output electrode 4 is an alternating voltage source Vₚ, which for instance supplies a unipolar sine-wave signal Vₚ with a frequency well above the resonance frequency of leaf spring 2. In this case the signal V_{PWM} on output electrode 4 is an amplitude-modulated sine. If signal Vₚ is kept unipolar, it need not be rectified. Signal Vₒ at the output of low-pass filter 7 has the average value of unipolar sine Vₚ, which varies with input signal Vᵢ. By way of alternative, a normal bipolar voltage Vₚ can also be fed to output electrode 4, in which case the output of low-pass filter 7 must be provided with an electronic or (micro-)mechanical rectifier diode.

Fig. 4 shows a schematic top view of the MEMS switch of amplifier 20 of fig. 3 by way of illustration of the layout of such a switch in an integrated circuit.

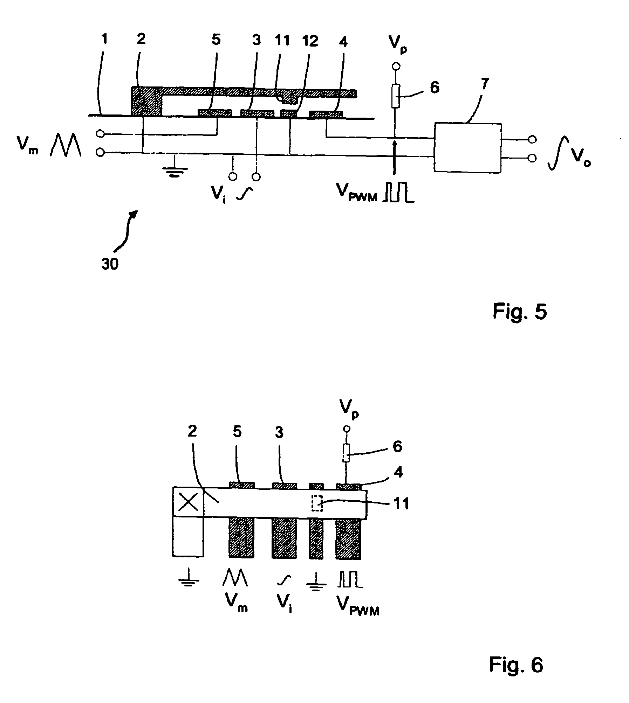

Fig. 5 shows an amplifier 30 which differs from amplifier 20 of fig. 3 in that a capacitive contact between leaf spring 2 and output electrode 4 is realized not by means of a dielectric, but by means of an air gap which occurs in the swung-down situation of leaf spring 2 in that, using a spacer 11, leaf spring 2 supports on its underside on a corresponding spacer 12 on substrate 1.

Fig. 6 shows a schematic top view of the MEMS switch of amplifier 30 of fig. 5 by way of illustration of the layout of such a switch in an integrated circuit.

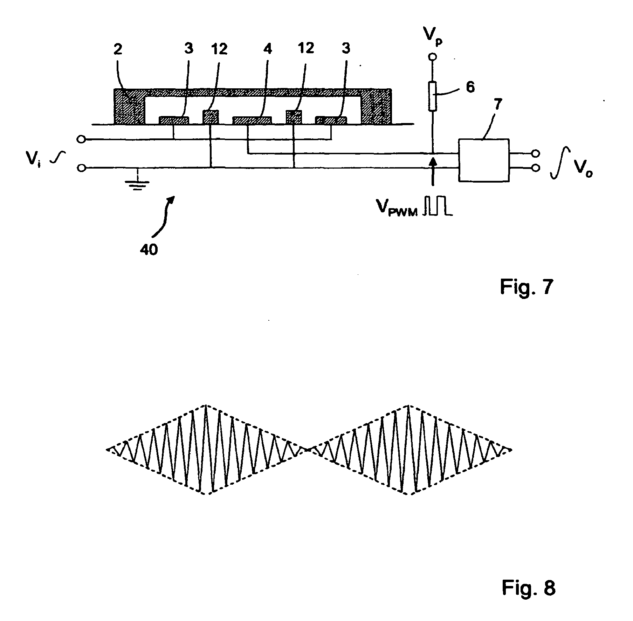

Fig. 7 shows an amplifier 40 which differs from amplifier 30 of fig. 5 in that the movable thin film 2 is embodied as a bridge which is supported at its two outer ends and which in the swung-down situation supports on two symmetrically placed spacers 12, input signal Vᵢ is fed to two symmetrically arranged input electrodes 3, and a separate actuator electrode is omitted. The function of the actuator electrode in this circuit is fulfilled by output electrode 4, on which via impedance 6 a sine-wave signal Vₚ is supplied with a frequency higher than the resonance frequency of bridge 2, which signal Vₚ is modulated with a triangular wave with a frequency just below the resonance frequency (shown in fig. 8), so that bridge 2 can follow the modulated signal but will only move with the effective value of the high-frequency sine-wave signal. At an input voltage Vᵢ = 0 V bridge 2 will be periodically swung downward and upward by the actuator signal Vₚ. The result hereof is that the capacitance value of bridge 2 will change in accordance with a block-like pattern and that the high-frequency component of actuator signal Vₚ will be modulated with an additional square wave due to the presence of impedance 6. A direct voltage is obtained when the signal from output electrode 4 is filtered with a low-pass filter 7 with a frequency lower than the modulation frequency of the actuator signal Vₚ. If the input voltage Vᵢ > 0 V, bridge 2 will be swung downward sooner as a result of the increased attraction force on bridge 2, and will remain swung down for a longer part of a period of actuator signal Vₚ. The amplitude-modulated signal on output electrode 4 will now have a lower average value and the voltage will decrease after low-pass filter 7 as input voltage Vᵢ increases. Because the output current depends on the capacity of bridge 2 and the value of impedance 6, a power amplifier has thus been created. Depending on the parameters of the circuit and Vₚ, a voltage amplifier can also be obtained. The absence of a separate actuator electrode in amplifier circuit 40 provides the advantage that this circuit is smaller, easier to produce and can function at higher speeds.

Because resistors, capacitors and coils can be integrated in known and simple manner into a circuit with MEMS technology, it lies within the reach of the skilled person to integrate into one circuit the MEMS switch and the low-pass filter in an amplifier device according to the invention, for instance an operational amplifier or a high-power amplifier.

It is emphasized that the above described exemplary embodiments serve to elucidate and not to limit the scope of the invention. It is possible for the skilled person to realize other embodiments within the inventive concept.

The movable thin film in a MEMS switch in an amplifier according to the invention can for instance be realized as a leaf spring suspended from one outer end, as a bridge carried at two outer ends or as a membrane, which thin film can move in the plane as well as out of the plane of the substrate.

The actuator means in a MEMS switch in a PWM amplifier according to the invention are described above as electrostatic drive means, although they can for instance also be realized in the form of electromagnetic or electrothermal drive means.

## Claims

1. Amplifier device (10, 20, 30, 40) of the pulse width modulation amplifier type (PWM amplifier), comprising a switch according to a micro-electromechanical system (MEMS-switch) for a signal to be amplified (Vᵢ), which MEMS switch comprises at least one substrate (1) on which are arranged
- a movable thin film (2) of an electrically conductive material,
- a first electrode (3) forming the input for the signal to be amplified (Vᵢ),
- a second electrode (4) forming the output for a pulse width-modulated signal (V_{PWM}), and
- actuator means (5, 6) for moving the thin film (2) subject to an actuator signal to be supplied (Vₘ, Vₚ) which is different from the signal to be amplified (Vᵢ), and to the signal to be amplified (Vᵢ),
wherein the actuator signal to be supplied (Vₘ, Vₚ) is a periodic signal having a frequency chosen such that it is much higher than the frequency of the signal to be amplified (Vᵢ), and
wherein the amplifier device is adapted to generate the pulse width-modulated signal (V_{PWM}) subject to the movement of the thin film (2).

2. Amplifier device (10, 20, 30) as claimed in claim 1, wherein the actuator means (5) are formed by a third electrode (5) which is adapted as actuator electrode for supplying a modulator signal (Vₘ) thereon for the purpose of moving the thin film (2), wherein the first (3) and the third electrode (5) form the inputs of a comparator circuit.

3. Amplifier device (10) as claimed in either of the claims 1-2, wherein the MEMS switch comprises a conductor-conductor contact of the thin film (2) and the second electrode (4).

4. Amplifier device (20, 30, 40) as claimed in either of the claims 1-2, wherein the MEMS switch comprises a capacitive contact (9) of the thin film (2) and the second electrode (4).

5. Amplifier device (30) as claimed in claim 4, wherein the capacitive contact is provided by an air gap between the thin film (2) and the second electrode (4), and the thin film (2) is provided on its side directed toward the substrate (1) with at least one spacer (11).

6. Amplifier device (30, 40) as claimed in either of the claims 4-5, wherein the capacitive contact is provided by an air gap between the thin film (2) and the second electrode (4), and the substrate (1) is provided on its side directed toward the thin film (2) with at least one spacer (12).

7. Amplifier device (10, 20, 30, 40) as claimed in any of the claims 1-6, wherein the electrically conductive material of the thin film (2) is selected from the group of aluminium (Al), polycrystalline silicon (Si), doped polycrystalline silicon, carbon (C), SiC, germanium (Ge), germanium-silicon alloys, titanium (Ti), titanium nitrides, nickel (Ni), copper (Cu), tantalum (Ta), tungsten (W), gold (Au) and stacks of at least two of these materials.

8. Amplifier device as claimed in claim 1, wherein the actuator means are electromagnetic drive means.

9. Amplifier device as claimed in claim 1, wherein the actuator means are electrothermal drive means.

## Patentansprüche

1. Verstärkereinrichtung (10, 20, 30, 40) vom Typ Puls-Weiten-Modulator-Verstärker (PWM-Verstärker), umfassend einen Schalter gemäß einem Mikro-Elektromechanischen System (MEMS-Schalter) für ein zu verstärkendes Signal (Vᵢ), welcher MEMS-Schalter mindestens ein Substrat (1) umfasst, auf dem angebracht sind
- ein beweglicher dünner Film (2) eines elektrisch leitenden Materials,
- eine erste Elektrode (3), die den Eingang für das zu verstärkende Signal (Vᵢ) bildet,
- eine zweite Elektrode (4), die den Ausgang für ein pulsweitenmoduliertes Signal (V_{PWM}) bildet, und
- Aktuatormittel (5, 6) zum Bewegen des dünnen Films (2) in Abhängigkeit von einem anzulegenden Aktuatorsignal (Vₘ, Vp), das sich von dem zu verstärkenden Signal (Vᵢ) unterscheidet, und von dem zu verstärkenden Signal (Vᵢ),
wobei das anzulegende Aktuatorsignal (Vₘ, Vₚ) ein periodisches Signal ist, das eine Frequenz aufweist, die derartig gewählt wurde, dass diese viel höher ist als die Frequenz des zu verstärkenden Signals (Vᵢ), und
wobei die Verstärkereinrichtung zum Generieren des pulsweitenmodulierten Signals (V_{PWM}) in Abhängigkeit von dem Bewegen des dünnen Films (2) eingerichtet ist.

2. Verstärkereinrichtung (10, 20, 30) nach Anspruch 1, in der die Aktuatormittel (5) durch eine dritte Elektrode (5) gebildet werden, die als Aktuatorelektrode zum daran Anbieten eines Modulatorsignals (Vₘ) zum Bewegen des dünnen Films (2) eingerichtet ist, wobei die erste (3) und die dritte Elektrode (5) die Eingänge einer Komparatorschaltung bilden.

3. Verstärkereinrichtung (10) nach einem der Ansprüche 1-2, in der der MEMS-Schalter einen Leiter-Leiter-Kontakt des dünnen Films (2) und der zweiten Elektrode (4) umfasst.

4. Verstärkereinrichtung (20, 30, 40) nach einem der Ansprüche 1-2, in dem der MEMS-Schalter einen kapazitiven Kontakt (9) des dünnen Films (2) und der zweiten Elektrode (4) umfasst.

5. Verstärkereinrichtung (30) nach Anspruch 4, in der der kapazitive Kontakt durch einen Luftspalt zwischen dem dünnen Film (2) und der zweiten Elektrode (4) bereitgestellt wird und der dünne Film (2) an seiner zu dem Substrat (1) hin gerichteten Seite mit mindestens einem Abstandhalter (11) ausgestattet ist.

6. Verstärkereinrichtung (30, 40) nach einem der Ansprüche 4-5, in der der kapazitive Kontakt durch einen Luftspalt zwischen dem dünnen Film (2) und der zweiten Elektrode (4) bereitgestellt wird und das Substrat (1) an seiner zu dem dünnen Film (2) hin gerichteten Seite mit mindestens einem Abstandhalter (12) ausgestattet ist.

7. Verstärkereinrichtung (10, 20, 30, 40) nach einem der Ansprüche 1-6, in der das elektrisch leitende Material des dünnen Films (2) aus der Gruppe Aluminium (Al), polykristallines Silicium (Si), dotiertes polykristallines Silicium, Kohlenstoff (C), SiC, Germanium (Ge), Germanium-Siliciumlegierungen, Titan (Ti), Titannitriden, Nickel (Ni), Kupfer (Cu,) Tantal (Ta), Wolfram (W), Gold (Au) und Schichten von mindestens zwei dieser Materialien ausgewählt ist.

8. Verstärkereinrichtung nach Anspruch 1, in der die Aktuatormittel elektromagnetische Antriebsmittel sind.

9. Verstärkereinrichtung nach Anspruch 1, in der die Aktuatormittel elektrothermische Antriebsmittel sind.

## Revendications

1. Dispositif d'amplificateur (10, 20, 30, 40) du type amplificateur à modulation d'impulsions en durée (amplificateur PWM), comprenant un commutateur basé sur un micro-système électromécanique (commutateur MEMS) pour un signal à amplifier (Vᵢ), ledit commutateur MEMS comprenant au moins un substrat (1) sur lequel sont agencés:
- un film mince mobile (2) constitué d'un matériau électriquement conducteur,
- une première électrode (3) qui forme l'entrée du signal à amplifier (Vᵢ);
- une deuxième électrode (4) qui forme la sortie d'un signal d'impulsions modulé en durée (V_{PWM}); et
- des moyens d'actionneur (5, 6) pour déplacer le film mince (2) selon un signal d'actionneur à fournir (Vₘ, Vₚ) qui est différent du signal à amplifier (Vᵢ), et selon le signal à amplifier (Vᵢ), et
dans lequel le signal d'actionneur à fournir (Vₘ, Vₚ) est un signal périodique dont la fréquence est choisie de manière à être nettement plus élevée que la fréquence du signal à amplifier (Vᵢ), et
dans lequel le dispositif d'amplificateur est adapté pour générer le signal d'impulsions modulé en durée (V_{PWM}) selon le déplacement du film mince (2).

2. Dispositif d'amplificateur (10, 20, 30) selon la revendication 1, dans lequel les moyens d'actionneur (5) sont formés par une troisième électrode (5) qui est conçue comme une électrode d'actionneur pour fournir un signal de modulateur (Vₘ) à celle-ci dans le but de déplacer le film mince (2), dans lequel les première (3) et troisième (5) électrodes forment les entrées d'un circuit de comparateur.

3. Dispositif d'amplificateur (10) selon l'une ou l'autre des revendications 1 et 2, dans lequel le commutateur MEMS comprend un contact conducteur - conducteur entre le film mince (2) et la deuxième électrode (4).

4. Dispositif d'amplificateur (20, 30, 40) selon l'une ou l'autre des revendications 1 et 2, dans lequel le commutateur MEMS comprend un contact capacitif (9) entre le film mince (2) et la deuxième électrode (4).

5. Dispositif d'amplificateur (30) selon la revendication 4, dans lequel le contact capacitif est formé par un entrefer entre le film mince (2) et la deuxième électrode (4), et le film mince (2) comporte au moins un écarteur (11) sur son côté qui est orienté vers le substrat (1).

6. Dispositif d'amplificateur (30, 40) selon l'une ou l'autre des revendications 4 et 5, dans lequel le contact capacitif est formé par un entrefer entre le film mince (2) et la deuxième électrode (4), et le substrat (1) comporte au moins un écarteur (12) sur son côté qui est orienté vers le film mince (2).

7. Dispositif d'amplificateur (10, 20, 30, 40) selon l'une quelconque des revendications 1 à 6, dans lequel le matériau électriquement conducteur qui constitue le film mince (2) est sélectionné dans le groupe comprenant l'aluminium (Al), le silicium polycristallin (Si), le silicium polycristallin dopé, le carbone (C), le SiC, le germanium (Ge), des alliages de germanium-silicium, le titane (Ti), des nitrures de titane, le nickel (Ni), le cuivre (Cu), le tantale (Ta), le tungstène (W), l'or (Au) et des superpositions d'au moins deux de ces matériaux.

8. Dispositif d'amplificateur selon la revendication 1, dans lequel les moyens d'actionneur sont des moyens de commande électromagnétiques.

9. Dispositif d'amplificateur selon la revendication 1, dans lequel les moyens d'actionneur sont des moyens de commande électrothermiques.
